# EUROPÄISCHE PATENTSCHRIFT

(11) **EP 3 592 181 B1**
(45) Veröffentlichungstag und Bekanntmachung des Hinweises auf die Patenterteilung: **27.01.2021**
(21) Anmeldenummer: 18709543.5
(22) Anmeldetag: 06.03.2018
(51) Int. Cl.: A47F 5/10, A47F 7/24

(54) **MOEBEL MIT WENIGSTENS EINER TRAGSTANGE**
PIECE OF FURNITURE HAVING AT LEAST ONE SUPPORT ROD
MEUBLE POURVU D'AU MOINS UNE TIGE SUPPORT

(30) Priorität: 06.03.2017 DE 102017104587
(43) Veröffentlichungstag der Anmeldung: 15.01.2020
(73) Patentinhaber: Dula-Werke Dustmann & Co. GmbH, 44225 Dortmund (DE)
(72) Erfinder: HOHEISEL, Stefan, 59192 Bergkamen (DE); REIMER, Alexander, 44267 Dortmund (DE)
(74) Vertreter: Buse, Mentzel, Ludewig Patentanwaltskanzlei
(86) Internationale Anmeldenummer: PCT/EP2018/055447
(87) Internationale Veröffentlichungsnummer: WO 2018/162463

(56) Entgegenhaltungen:
- EP-A1- 2 499 935
- WO-A2-2005/099522

## Beschreibung

Die Erfindung betrifft ein Möbel mit wenigstens einer Tragstange der im Oberbegriff von Anspruch 1 angegebenen Art. Derartige Möbel finden vielfach Verwendung, vor allem im Ladenbau, auf Messen, bei Ausstellungen, können aber auch in Wohn- und Geschäftsräumen, Büros und Ähnlichem eingesetzt werden. Die Tragstange wird dabei an einer Platte angeordnet, wobei an der Tragstange weitere Elemente vorgesehen sein können, wie Warenträger, dekorative Elemente, informative Elemente oder Ähnliches. Als Warenträger kommen dabei Regelböden, Abhängearme, Konfektionsstangen, Haken und Anderes in Frage.

Eine derartige Vorrichtung beschreibt die EP 2 499 935 A1. Hier ist ein Möbel mit einer Tragstange vorgesehen, wobei wenigstens eine erste Platte mit einer ersten Ausnehmung und eine darunter angeordnete zweite Platte mit einer zweiten Ausnehmung vorgesehen sind, wobei das eine Ende der Tragstange beide Ausnehmungen durchgreifen kann, um in der Platte angeordnet zu werden. Die Tragstange weist dabei einen sternförmigen Querschnitt auf, wobei die beiden Ausnehmungen ebenfalls sternförmig und vorzugsweise ähnlich zum Querschnitt der Tragstange ausgebildet sind. Nachteilig bei dieser Anordnung ist es, dass es nicht vorgesehen ist, elektrischer Verbraucher, wie Beleuchtungseinrichtungen, Displays, Lautsprecher, Kameras oder Ähnliches mit anzuschließen. Werden derartige Verbraucher gewünscht, so müssen diese entweder mit Hilfe einer Elektrofachkraft nachgerüstet werden oder die Geräte müssen zusätzlich über Steckdosen angeschlossen und an dem Möbel angebracht werden. Dies ist jedoch unpraktisch, insbesondere wenn hierfür Fachpersonal erforderlich ist, und das Möbel büßt viel von seiner Flexibilität und auch von seinen optischen Eigenschaften ein.

Aufgabe der Erfindung ist es daher, den vorgenannten Nachteil zu vermeiden und das Möbel um eine Elektrifizierung zu erweitern, welche einfach funktioniert, auch wenn die Tragstangen montiert und demontiert werden wobei dafür kein Fachpersonal erforderlich ist, um das Möbel trotzdem nicht in seiner Flexibilität einzuschränken. Diese Aufgabe wird durch die kennzeichnenden Merkmale von Anspruch 1 gelöst, denen folgende besondere Bedeutung zukommt.

Die Tragstange umfasst elektrische Leiterbahnen mittels derer ein Verbraucher, der mittelbar oder unmittelbar an der Tragstange vorgesehen ist, mit elektrischer Energie versorgt werden kann. An dem einen Ende der Tragstange sind dabei elektrische Kontaktstellen vorgesehen, um die elektrischen Leiterbahnen mit elektrischer Energie zu versorgen. Weiterhin ist eine Platine vorgesehen, welche elektrische Gegenkontaktstellen aufweist, die mit den elektrischen Kontaktstellen in Wirkverbindung bringbar sind. Die Platine ist dabei so beschaffen, dass die Kontaktierung zwischen den elektrischen Kontaktstellen und den elektrischen Gegenkontaktstellen erfolgt, unabhängig von der Ausrichtung der Tragstange in den Ausnehmungen.

Hierdurch erfolgt eine einfache Kontaktierung zwischen den elektrischen Kontaktstellen und den elektrischen Gegenkontaktstellen. Die Platine wird dabei einmalig bei der Montage der ersten und zweiten Platte auf üblichem Wege mit elektrischer Energie versorgt, beispielsweise über eine Lötverbindung. Wird dann eine erfindungsgemäße Tragstange in die erste und zweite Ausnehmung eingebracht, erfolgt die elektrische Kontaktierung und damit die Energieversorgung des bzw. der Verbraucher automatisch. Dies geschieht auch, wenn die Tragstange von einem ersten Paar Ausnehmungen zu einem anderen Paar Ausnehmungen versetzt wird und ist unabhängig von der genauen Ausrichtung der achsensymmetrischen Tragstange. Eine Bedienperson kann somit, falls mehrere Paare von Ausnehmungen vorhanden sind, eine Tragstange von einem Ausnehmungspaar in ein anderes Ausnehmungspaar umstecken bzw. die Tragstange entnehmen und wieder in das gleiche Ausnehmungspaar stecken, ohne dass eine Fachkraft die elektrische Energieversorgung wieder herstellen müsste. Die Tragstangen können in das Ausnehmungspaar eingesteckt und wieder entnommen werden, wobei beim Einstecken und Herstellen des Montagezustandes auch gleichzeitig automatisch die Elektrifizierung vorgenommen wird. Die Platten selber können am Boden oder auch an einer Wand befestigt sein. Bei einer Befestigung in der Wand, spezielle Tragstangen verwendet werden, welche auf ihrer einen Seite an einem Zacken des sternförmigen Querschnitts eine Aussparung aufweisen, mit der sich die Tragstange im Montagezustand an der zweiten Ausnehmung in der zweiten Platte verhaken kann, um ein unbeabsichtigtes Herausrutschen zu verhindern. Auch können die Tragstangen noch auf der der einen Seite abgewandten anderen Seite einen Vorsprung aufweisen, um beispielsweise einen Regalboden sicher zu haltern oder um bei der Verwendung als Abhängearm zu verhindern, dass ein Kleiderbügel von der Tragstange rutschen kann.

Eine erfindungsgemäße Platine ist vorteilhafterweise so ausgebildet, dass sie einen zentralen ersten Bereich umfasst, der in etwa in Form eines Schlüsselloches ausgebildet ist und der eine erste elektrische Gegenkontaktstelle bildet, während ein den ersten Bereich teilweise umgebender zweiter Bereich vorgesehen ist, der eine zweite elektrische Gegenkontaktstelle bildet, wobei die beiden Bereiche so angeordnet sind, dass immer die eine elektrische Kontaktstelle der Tragstange mit dem ersten Bereich und die andere elektrische Kontaktstelle der Tragstange mit dem zweiten Bereich in Wirkverbindung steht, unabhängig von der Ausrichtung der Tragstange. Durch die besondere Form der Platine ist es möglich, beide Kontaktbereiche zur Außenkante der Platine zu führen, von wo aus sie auf üblichem Wege einer elektrischen Stromversorgung zugeführt werden kann. Sind beispielsweise vier Einsteckrichtungen für die Tragstange möglich und vorgesehen, so kann der schlüssellochförmige erste Bereich der Platine so ausgerichtet sein, dass der Teil, wo der zweite Bereich den ersten Bereich nicht umschließt, auf 45 Grad ausgerichtet ist, wenn die Kontaktierung der Platine auf 0 Grad, 90 Grad, 180 Grad und 270 Grad erfolgt. Somit kann sichergestellt werden, dass das Zusammenwirken der elektrischen Kontaktstellen und der Platine keinen Kurzschluss hervorruft, da immer eine Kontaktstelle mit dem ersten Bereich und die andere Kontaktstelle mit dem zweiten Bereich in Verbindung steht. Selbstverständlich sind hier auch andere Formen der Platine und der Tragstange denkbar.

Bevorzugterweise ist unterhalb der zweiten Ausnehmung eine Halterung für die Platine vorgesehen. Hierdurch wird die Platine vor mechanischer Beanspruchung durch die Tragstangen geschützt. Auch ist es so möglich, ein bestehendes Möbelstück, welches keine Elektrifizierung aufweist, nachzurüsten, indem beispielsweise eine Halterung mit Platine unterhalb der zweiten Ausnehmung angeordnet und angeschlossen wird. Dann müssen lediglich die Tragstangen ebenfalls nachgerüstet oder durch Tragstangen mit elektrischen Leiterbahnen ausgetauscht werden und schon kann die Elektrifizierung des bestehenden Möbels erfolgen.

Besonders einfach ist es, wenn die elektrischen Kontaktstellen als steckerförmiger Kontaktausnehmer ausgebildet sind. Diese bieten einen gewissen mechanischen Schutz und stellen eine sichere Kontaktierung der Gegenkontaktstellen auf der Platine sicher. Vorteilhafterweise weist dabei die Tragstange noch eine Aufnahme auf, in welche der Kontaktabnehmer einbringbar ist. Hierdurch werden sowohl der Kontaktabnehmer als auch die elektrischen Kontaktstellen zusätzlich geschützt, da sie quasi in die Tragstange eingebracht werden. So kann beim Demontieren und Lagern der Tragstangen nicht so leicht eine Beschädigung der elektrischen Kontaktstellen erfolgen. Darüber hinaus ist der Kontaktabnehmer im Montagezustand der Tragstange unterhalb der ersten Platte angeordnet und somit von außen nicht sichtbar. Hierdurch ergibt sich ein gutes optisches Gesamtbild des Möbels. Der Kotaktabnehmer vereinfacht dabei das Einstecken der elektrischen Kontaktstellen in die erste Ausnehmung.

Bevorzugterweise kann die Tragstange pulverbeschichtet sein. Dies ist es hinlänglich bekanntes Verfahren und ermöglicht es, eine Tragstange vorzusehen, die ein ansprechendes Äußeres hat und vor Korrosion und Beschädigung geschützt ist. Darüber hinaus kann die Pulverbeschichtung in verschiedensten Arten und Weisen erfolgen, so dass verschiedenste Farbgebungen und Ähnliches möglich sind.

Besonders unauffällig ist das Aufbringen der elektrischen Leiterbahnen, wenn diese auf die Tragstange aufgedruckt werden. Dies ist mit heute üblichen 3D-Duckverfahren möglich, die auch das Drucken von Metallen oder anderen elektrisch leitenden Materialien erlauben. Alternativ können die elektrischen Leiterbahnen selbstverständlich auf die Tragstange aufgeklebt werden. Dies ist insbesondere auch bei einer nachträglichen Elektrifizierung, also einem Nachrüsten einer bestehenden Tragstange sinnvoll. Bei beiden Methoden ist es dabei vorteilhaft, wenn die Leiterbahnen möglichst flach ausgebildet werden, damit sie optisch nicht so hervortreten und den optischen Gesamteindruck der Tragstange nicht stören.

Die Tragstange selbst kann aus mehreren flächigen Bauteilen bestehen, die zusammengesteckt werden, insbesondere unter Zwischenschaltung einer oder mehrerer Aufnahmen. Dabei sind die flächigen Bauteile vorzugsweise aneinander festlegbar, insbesondere durch Schweißen, Kleben oder Ähnliches. Die flächigen Bauteile können dabei kongruent zueinander ausgebildet sein, was das Fertigungsverfahren der flächigen Bauteile vereinfacht und damit preiswerter macht.

Eine erste Ausführungsform des Möbels sieht vor, dass eine Buchse vorgesehen ist, welche die erste und die zweite Platte bildet, wobei die Buchse über je eine erste und eine zweite Ausnehmung und eine Platine verfügt und eine Tragstange in die Buchse einbringbar ist, wobei die Buchse in einem Möbelstück anordbar ist. Hier ist es möglich, Möbelstücke aus allen möglichen Materialien mit einer derartigen Buchse zu versehen und dann je eine Tragstange in jede der Buchsen einzusetzen.

Bei einer weiteren Ausführungsform des Möbels ist ein Gehäuse vorgesehen, welches die erste und die zweite Platte bildet, wobei die erste Platte über mehrere erste und die zweite Platte über mehrere zweite Ausnehmungen verfügt. Vorzugsweise ist eine einzige Platine in Einsteckrichtung unterhalb der zweiten Ausnehmungen angeordnet und zwar derart, dass unterhalb jeder der zweiten Ausnehmungen ein Paar von Gegenkontaktstellen auf der Platine vorhanden ist. In jede der ersten und zweiten Ausnehmungen ist jeweils eine Tragstange einbringbar, wobei es jedoch auf den konkreten Anwendungsfall ankommt, wie viele Tragstangen vorgesehen sind und in welche Ausnehmungen diese eingebracht werden. Hier können also unterschiedliche Anzahlen von Tragstangen beliebig in den Ausnehmungen angeordnet werden. Durch die einzelne Platine ist nur eine Installation bzw. ein Anschließen an die elektrische Stromversorgung notwendig und die Tragstangen können in jedes Paar von Ausnehmungen durch einfaches Einstecken und Herstellen des Montagezustandes elektrisch kontaktiert werden, wobei die vorhandenen Verbraucher mit Strom versorgt werden können.

Darüber hinaus können noch eine oder mehrere weitere Elemente einstückig mit einer Tragstange ausgebildet sein bzw. an dieser festgelegt werden.

Erfindungsgemäß vorteilhaft ist es, wenn die Tragstange und/oder die erste Platte und/oder die zweite Platte und/oder das Gehäuse und/oder die Buchse ganz oder teilweise aus Metall und/oder Kunststoff und/oder Glas und/oder aus einem Verbundmaterial bestehen. Die genauen Materialien, die hier zum Einsatz kommen, sind variabel und können je nach Einsatzzweck variieren. Die Tragstange und/oder die erste und/oder die zweite Platte können dabei zumindest bereichsweise aus einem durchsichtigem Material bestehen, welcher beleuchtet werden kann, wobei die Beleuchtung bereits durch eine einfaches Einbringen der Tragstange in die beiden Ausnehmungen und Kontaktierung mit den Gegenkontaktstellen auf der Platine mit elektrischer Energie versorgt werden kann.

Weitere Vorteile und Ausführungsbeispiele ergeben sich aus der nachfolgenden Beschreibung, den Unteransprüchen sowie den Zeichnungen. In den Zeichnungen ist die Erfindung in zwei Ausführungsbeispielen dargestellt. Es zeigen:
- Fig. 1:: eine erfindungsgemäße Vorrichtung mit Buchse, perspektivisch,
- Fig. 2:: die Vorrichtung aus Fig. 1 im Montagezustand,
- Fig. 3:: die Vorrichtung aus Fig. 2 in Seitenansicht,
- Fig. 4:: die Vorrichtung aus Fig. 2 im Schnitt,
- Fig. 5:: das eine Ende der erfindungsgemäßen Tragstange mit Kontaktabnehmer,
- Fig. 6:: die Buchse aus den Fig. 1 bis 4 mit Halterung und Platine,
- Fig. 7:: die erfindungsgemäße Buchse mit Tragstange vor dem Einbau in ein Möbelstück,
- Fig. 8:: die Vorrichtung gemäß Fig. 7 im Montagezustand, perspektivisch,
- Fig. 9:: die Vorrichtung aus Fig. 8 in Seitenansicht,
- Fig. 10:: ein erfindungsgemäßes Gehäuse in Draufsicht,
- Fig. 11:: das Gehäuse von Fig. 10 mit Tragstange vor dem Montagezustand,
- Fig. 12:: die Elemente aus Fig. 11 im Montagezustand,
- Fig. 13a:: ein Gehäuse mit Platine für die Bodenmontage als Explosionsdarstellung,
- Fig. 13b:: eine Gehäuse mit Platine für die Wandmontage in Explosionsdarstellung,
- Fig. 14:: ein fertig montiertes Möbel mit Warenträgern und Gehäuse sowie zwei Tragstangen,
- Fig. 15:: ein Beispiel für einen Verbraucher an einer Tragstange.

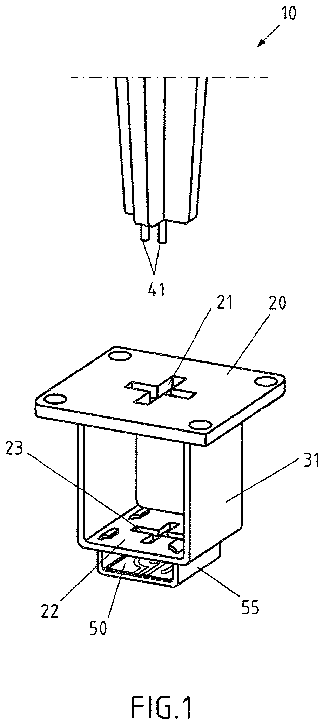

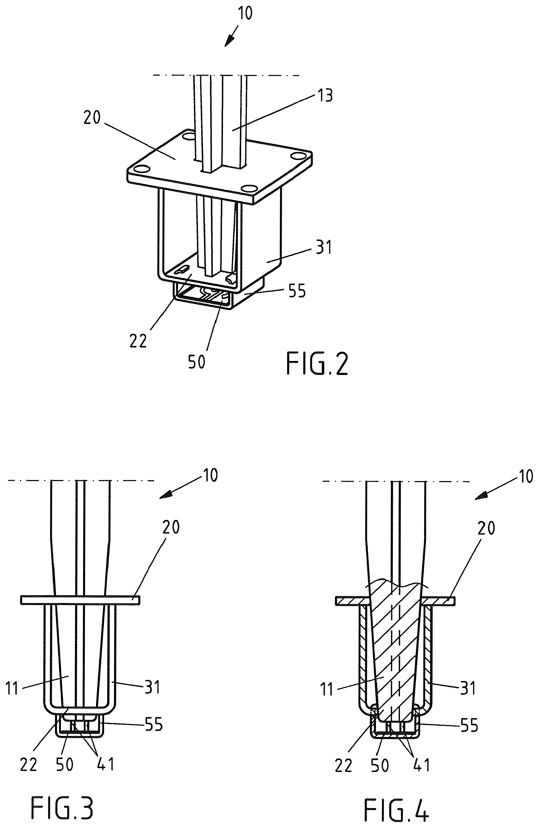

Die Fig. 1 bis 4 zeigen ein erstes Ausführungsbeispiel der erfindungsgemäßen Vorrichtung. Die Tragstange 10 besitzt einen sternförmigen Querschnitt 13 und ist mit ihrem einen Ende 11 durch eine erste Ausnehmung 21 in der ersten Platte 20 und durch eine parallel zu dieser ersten Ausnehmung 21 angeordnete zweite Ausnehmung 23 in der zweiten Platte 22 führbar. Unterhalb der zweiten Platte 22, die die zweite Ausnehmung 23 aufweist, ist eine Halterung 55 mit einer Platine 50 angeordnet.

Das eine Ende 11 der Tragstange 10 weist eine Verjüngung 14 auf sowie elektrische Kontaktstellen 41. Mit dieser Verjüngung 14 greift die Tragstange 10 in die beiden Ausnehmungen 21, 23 ein, wobei nach Durchdringen der zweiten Ausnehmung 23 die elektrischen Kontaktstellen 41 mit den elektrischen Gegenkontaktstellen 51, 52 auf der Platine 50 in elektrische Wirkverbindung gebracht werden. Die beiden Platten 20, 22 sind parallel zueinander angeordnet und parallel dazu ist auch die Halterung 55 mit der Platine 50 ausgerichtet. Die beiden Platten 20, 22 und die Halterung 55 sind dabei so angeordnet, dass die erste Ausnehmung 21 in der ersten Platte 20 die zweite Ausnehmung 23 in der zweiten Platte 22 sowie die Platine 50 auf der Halterung 55 miteinander fluchten und die elektrischen Kontaktstellen 41 an der Tragstange 10 mit den elektrischen Gegenkontaktstellen 51, 52 auf der Platine 50 beim Herstellen des Montagezustandes 30.1 der Tragstange 10 automatisch in elektrische Wirkverbindung gebracht werden.

In diesem Ausführungsbeispiel bilden die beiden Platten 20 und 22 eine Buchse 31, in der je eine erste 21 und zweite Ausnehmung 23 sowie eine Platine 50 angeordnet sind. Somit kann in dieser Buchse 31 genau eine Tragstange 10 angeordnet werden. Die Tragstange 10 selber besteht aus zwei flächigen Bauteilen 16, die zusammengesteckt und miteinander verschweißt sind. Die hier gezeigte Tragstange 10 weist dabei einen sternförmigen Querschnitt 13 mit vier Zacken auf. Selbstverständlich ist es auch möglich, anders geformte sternförmige Querschnitte vorzusehen, die mehr oder weniger Zacken aufweisen. Der Querschnitt 13 der Tragstange 10 und die beiden Ausnehmungen 21, 23 sind ähnlich zueinander ausgebildet. Die elektrischen Leiterbahnen 40 sind an einem der Zacken der Tragstange 10 flächig angeordnet.

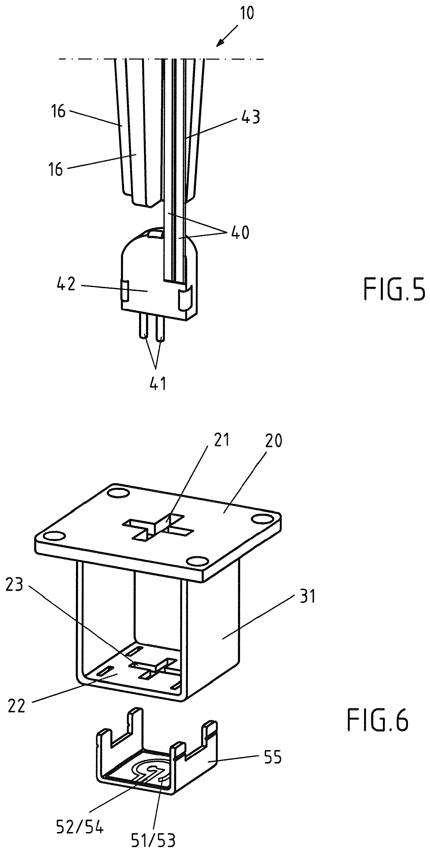

In Fig. 5 ist erkennbar, dass an dem einen Ende 11 der Tragstange 10 ein Paar von elektrischen Leiterbahnen 40 angeordnet ist. Diese sind flach ausgebildet, damit sie den optischen Gesamteindruck der Tragstange 10 möglichst wenig beeinflussen. Die elektrischen Leiterbahnen 40 können dabei entweder direkt auf den entsprechenden flächigen Bauteil 16 der Tragstange 10 aufgedruckt oder auf diesen aufgeklebt werden. Auch ist es möglich, die elektrischen Leiterbahnen 40 auf der Tragstange 10 bzw. dem flächigen Bauteil 16 anzubringen und danach noch eine Beschichtung, beispielsweise eine Pulverbeschichtung, vorzusehen, so dass die elektrischen Leiterbahnen 40 kaum oder gar nicht sichtbar sind.

Des Weiteren ist eine Aufnahme 43 an dem flächigen Bauteil 16 der Tragstange 10, welcher die elektrischen Leiterbahnen 40 aufweist, vorgesehen, in welche ein Kontaktabnehmer 42, welcher die elektrischen Kontaktstellen 41 beinhaltet, aufgenommen werden kann. Auch der Kontaktabnehmer 42 mit den beiden elektrischen Kontaktstellen 41 ist dargestellt. Dieser ist sehr klein, flach und unauffällig gehalten. Die Aufnahme 43 in der Tragstange 10 sorgt dafür, dass der Kontaktabnehmer 42 korrekt platziert wird und damit auch eine richtige Kontaktierung zwischen den elektrischen Leiterbahnen 40 bzw. den elektrischen Kontaktstellen 41 und der Platine 50 bzw. den elektrischen Gegenkontaktstellen 51, 52 hergestellt wird. Darüber hinaus ist der Kontaktabnehmer 42 in der Aufnahme 43 optisch versteckt angeordnet, insbesondere da dieser Bereich auch im Montagezustand 30.1 zwischen der ersten Platte und der zweiten Platte 22 angeordnet ist. Aber die Aufnahme 43 sorgt auch dafür, dass sich die elektrischen Kontaktstellen 41 bei Einstecken der Tragstange 10 in die Ausnehmungen 21, 23 nicht verhaken können.

Fig. 6 zeigt einen genaueren Aufbau der Buchse 31 mit erster Platte 20 und zweiter Platte 22 sowie erste Aufnahme 21 und zweiter Aufnahme 23 sowie mit der Platine 50 und der Halterung 55. An der Platine 50 erkennt man den ersten Bereich 53, der die erste elektrische Gegenkontaktstelle 51 bildet sowie den zweiten Bereich 54, der die zweite elektrische Gegenkontaktstelle 52 bildet. Beide Gegenkontaktstellen 51, 52 sind konzentrisch zueinander aufgebaut, wobei der erste Bereich 53 in etwa die Form eines Schlüsselloches aufweist. Hier ist der längliche Teil des ersten Bereiches 53 des Schlüssellochs um ca. 45 Grad versetzt, so dass es nicht zu einem Kurzschluss kommen kann, sondern im Montagezustand 30.1 immer die elektrischen Kontaktstellen 41 an den elektrischen Gegenkontaktstellen 51, 52 anliegen und einen elektrischen Kontakt herstellen. Die Halterung 55 und die Platine 50 sind so beschaffen, dass sie bei bestehenden Vorrichtungen und Buchsen 31, welche nicht elektrifiziert sind, nachgerüstet werden können.

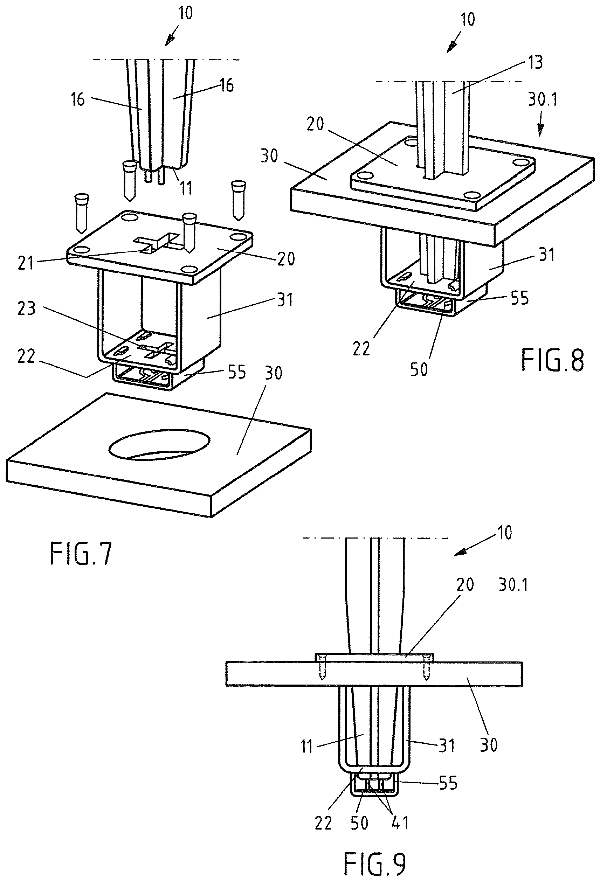

In den Fig. 7 bis 9 wird gezeigt, wie die Buchse 31 in einem Möbelstück Verwendung findet, um das Möbel 30 herzustellen. Hierzu wird die Buchse 31 in das Möbelstück eingesetzt und dort festgelegt, vorzugsweise verschraubt. Die Platine 50 muss dann noch mit einer elektrischen Stromversorgung kontaktiert werden, beispielsweise durch eine Lötverbindung, um eine elektrische Versorgung der Leiterbahnen 40 und eventueller Verbraucher 18 sicherzustellen. Danach ist es möglich, die Tragstange 10 beliebig in die Ausnehmungen 21, 23 der Buchse 31 einzubringen und aus dieser wieder zu entfernen. Die elektrische Kontaktierung erfolgt beim Einbringen der Tragstange 10 in die Ausnehmungen 21, 23 dabei automatisch.

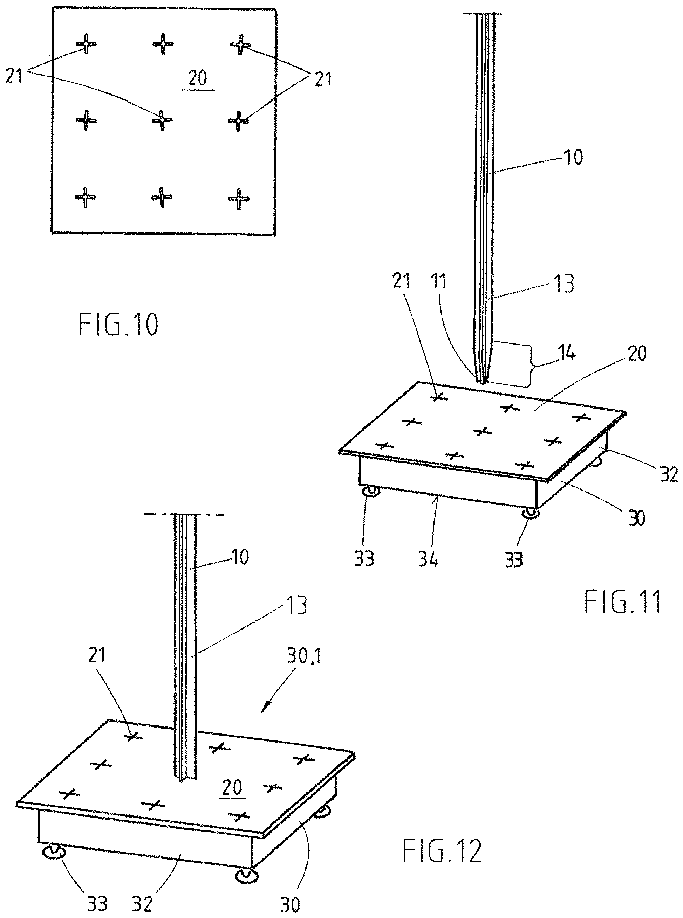

Die Fig. 10 bis 12 zeigen ein weiteres Ausführungsbeispiel der erfindungsgemäßen Vorrichtung. Hier ist ein Gehäuse 32 vorgesehen, welches die erste Platte 20 und die zweite Platte 22 bildet. Unterhalb der zweiten Platte 22 ist dann noch die Platine 50 vorgesehen. In der ersten Platte 20 sind dabei mehrere erste Ausnehmungen 21 vorgesehen, während die zweite Platte 22 mehrere zweite Ausnehmungen 23 aufweist. Die Platine 50 weist mehrere Paare von elektrischen Gegenkontaktstellen 51, 52 auf und zwar jeweils für jedes Paar von Ausnehmungen 21, 23, ein Paar von Gegenkontaktstellen 51, 52. Die ersten Ausnehmungen 21 und zweiten Ausnehmungen 23 sowie die Gegenkontaktstellen 51, 52 sind dabei im Wesentlichen genauso ausgestaltet, wie in den bisher gezeigten Figuren. Die Ausnehmungen 21, 23 sind wiederum ähnlich zum Querschnitt 13 der Tragstange 10 und die elektrischen Gegenkontaktstellen 51, 52 weisen wieder die beschriebenen ersten 53 und zweiten Bereiche 54 auf. Da nur eine Platine 50 für alle Gegenkontaktstellen 51, 52 verwendet wird, muss auch hier nur eine einzige elektrische Kontaktierung an eine Stromversorgung erfolgen. Die Tragstange 10 wird wieder in bekannter Weise mit ihrem einen Ende 11, welches verjüngt 14 ausgebildet ist und die elektrischen Kontaktstellen 41 für die elektrischen Leiterbahnen 40 aufweist, in die ersten 21 und zweiten Ausnehmungen 23 eingebracht und automatisch mit den Gegenkontaktstellen 51, 52 auf der Platine 50 kontaktiert.

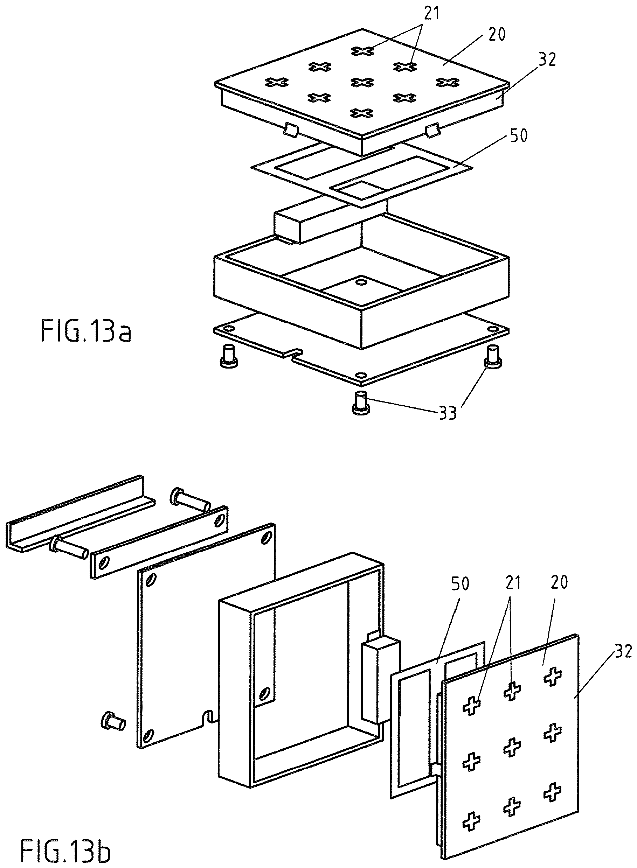

Die Fig. 13a und 13b zeigen nähere Ausgestaltungen und Explosionsdarstellungen dieser Ausführungsformen. Bei beiden Figuren wurde die Platine 50 nur exemplarisch dargestellt, und auf die Darstellung der Gegenkontaktstellen 51, 52 aus Gründen der Übersichtlichkeit verzichtet. Fig. 13a zeigt dabei in einer Art Explosionsdarstellung ein erfindungsgemäßes Möbel 30 mit Gehäuse 32, welches als Bodenmöbel, also als auf dem Boden stehendes Möbel 30, vorgesehen ist. Hierzu sind auch Füße 33 vorgesehen, um das Möbel 30 auf dem Boden auszurichten.

Fig. 13b zeigt eine Variante, ebenfalls mit Gehäuse 32, wobei dieses Möbel 30 an der Wand montiert werden kann. Somit sind die dort eingebrachten Tragstangen 10 dann horizontal ausgerichtet. Vorzugsweise weist eine hierfür vorgesehene Tragstange 10 an ihrem einen Ende 11 an einem Zacken ihres sternförmigen Querschnitts 13 eine Aussparung auf, mit der sie sich im Monatezustand in der zweiten Ausnehmung 23 verhaken kann. So kann die Tragstange 10 nicht aus den beiden Ausnehmungen 21, 23 herausrutschen, so dass die Kontaktierung der elektrischen Kontaktstellen 41 und der elektrischen Gegenkontaktstellen 51, 52 bestehen bleibt.

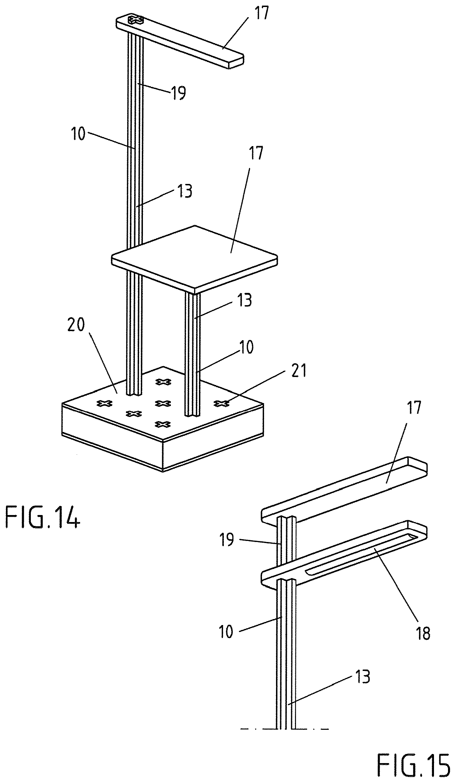

Schließlich zeigt die Fig. 14 eine beispielhaftes fertiges Möbel 30 mit zwei Tragstangen 10 sowie mit Warenträgern. Die Füße 33 sind hier durch eine Abdeckung verdeckt, so dass sich ein schönes optisches Gesamtbild ergibt.

Fig. 15 zeigt exemplarisch einen elektrischen Verbraucher 18, hier eine Beleuchtung. Der Verbraucher 18 in an dem anderen Ende 19 einer Tragstange 10 angeordnet. Die Beleuchtung kann beispielsweise darunter befindliche Auslagen mit Waren oder Ähnlichem beleuchten oder auch anderen Beleuchtungszwecken dienen.

Abschließend sei noch darauf hingewiesen, dass die hier dargestellten Ausführungsformen lediglich beispielhafte Verwirklichungen der Erfindung sind. Diese ist nicht darauf beschränkt. Es sind vielmehr noch Abänderungen und Abwandlungen möglich.

### Bezugszeichenliste:

- 10: Tragstange
- 11: Eines Ende von 10
- 12: Weiteres Element
- 13: Sternförmiger Querschnitt von 10
- 14: Verjüngung an 10
- 15: Einsteckrichtung von 10
- 16: Flächiges Bauteil von 10
- 17: Warenträger
- 18: Verbraucher
- 19: Anderes Ende von 10
- 20: Erste Platte
- 21: Erste Ausnehmung
- 22: Zweite Platte
- 23: Zweite Ausnehmung
- 30: Möbel
- 30.1: Montagezustand
- 31: Buchse
- 32: Gehäuse
- 33: Fuß
- 34: Dem Boden zugewandte Seite von 30 oder 32
- 40: Elektrische Leiterbahn
- 41: Elektrische Kontaktstellen
- 42: Kontaktabnehmer
- 43: Aufnahme an 10
- 50: Platine
- 51: Erste elektrische Gegenkontaktstelle
- 52: Zweite elektrische Gegenkontaktstelle
- 53: Erster Bereich an 50
- 54: Zweiter Bereich an 50
- 55: Halterung

## Patentansprüche

1. Möbel (30) mit wenigstens einer Tragstange (10) und mit zumindest einer ersten Platte (20), auf welcher die Tragstange oder Tragstangen (10) installierbar sind,
wobei die erste Platte (20) ein oder mehrere erste Ausnehmungen (21) aufweist, wobei in jede dieser ersten Ausnehmungen (21) eine Tragstange (10) mit ihrem einen Ende (11) einbringbar ist,
wobei jede der Tragstangen (10) senkrecht an der ersten Platte (20) montierbar ist,
wobei die Tragstange (10) einen sternförmigen achsensymmetrischen Querschnitt (13) hat, der an dem der ersten Platte (20) zugewandten einen Ende (11) sich verjüngt (14)
und die Form der ersten Ausnehmungen (21) an den sternförmigen Querschnitt (13) der Tragstange (10) angepasst ist, vorzugsweise so, dass sie ähnlich zu dem sternförmigen Querschnitt (13) der Tragstange (10) ausgebildet ist,
wobei wenigstens eine zweite Ausnehmung (23) vorgesehen ist, welche sich in einer zweiten Platte (22) parallel in Einsteckrichtung (15) der Tragstange (10) hinter der ersten Ausnehmung (21) in der ersten Platte (20) befindet,
wobei die zweite Ausnehmung (23) vorzugsweise ähnlich, aber kleiner ausgebildet ist als die erste Ausnehmung (21)
und wobei die Tragstange (10) mit ihrem einen Ende (11) in die erste (21) und in die zweite Ausnehmung (23) in mehreren Ausrichtungen, welche durch Rotation der Tragstange (10) um die Mittelachse entstehen, einsteckbar ist und hierdurch ein Montagezustand (30.1) entsteht,
**dadurch gekennzeichnet,**
**dass** die Tragstange (10) elektrische Leiterbahnen (40) umfasst, mittels welchen ein Verbraucher (18), der mittelbar oder unmittelbar an der Tragstange (10) vorgesehen ist, mit elektrischer Energie versorgt werden kann,
wobei an dem einen Ende (11) der Tragstange (10) elektrische Kontaktstellen (41) vorgesehen sind, um die elektrischen Leiterbahnen (40) mit elektrischer Energie zu versorgen
und **dass** eine Platine (50) vorgesehen ist, welche elektrische Gegenkontaktstellen (51, 52) aufweist, die mit den elektrischen Kontaktstellen (41) in Wirkverbindung bringbar sind,
wobei die Platine (50) so beschaffen ist, dass die Kontaktierung zwischen den elektrischen Kontaktstellen (41) und den elektrischen Gegenkontaktstellen (51, 52) erfolgt, unabhängig von der Ausrichtung der Tragstange (10), lediglich durch Einbringen der Tragstange (10) in jeweils eine erste (21) und eine zweite Ausnehmung (23).

2. Möbel (30) nach Anspruch 1, **dadurch gekennzeichnet, dass** die Platine (50) einen zentralen ersten Bereich (53) aufweist, der in Form eines Schlüsselloches ausgebildet ist und der eine erste elektrische Gegenkontaktstelle (51) bildet, während ein den ersten Bereich (53) teilweise umgebender zweiter Bereich (54) vorgesehen ist, der eine zweite elektrische Gegenkontaktstelle (52) bildet, wobei die beiden Bereiche so angeordnet sind, dass immer die eine elektrische Kontaktstelle (41) der Tragstange (10) mit dem ersten Bereich (53) und die andere elektrische Kontaktstelle (41) der Tragstange (10) mit dem zweiten Bereich (54) in Wirkverbindung steht, unabhängig von der Ausrichtung der Tragstange (10).

3. Möbel (30) nach Anspruch 1 oder 2, **dadurch gekennzeichnet, dass** unterhalb der zweiten Ausnehmung (23) eine Halterung (55) für die Platine (50) vorgesehen ist.

4. Möbel (30) nach einem der Ansprüche 1 bis 3, **dadurch gekennzeichnet, dass** die elektrischen Kontaktstellen (41) als steckerförmiger Kontaktabnehmer (42) ausgebildet sind.

5. Möbel (30) nach Anspruch 4, **dadurch gekennzeichnet, dass** die Tragstange (10) eine Aufnahme (43) aufweist, in welche der Kontaktabnehmer (42) einbringbar ist.

6. Möbel (30) nach einem der Ansprüche 1 bis 5, **dadurch gekennzeichnet, dass** die Tragstange (10) pulverbeschichtet ist.

7. Möbel (30) nach einem der Ansprüche 1 bis 6, **dadurch gekennzeichnet, dass** die elektrischen Leiterbahnen (40) auf die Tragstange (10) aufgedruckt sind.

8. Möbel (30) nach einem der Ansprüche 1 bis 6, **dadurch gekennzeichnet, dass** die elektrischen Leiterbahnen (40) auf die Tragstange (10) aufgeklebt sind.

9. Möbel (30) nach einem der Ansprüche 1 bis 8, **dadurch gekennzeichnet, dass** die Tragstange (10) aus mehreren vorzugsweise zueinander kongruenten flächigen Bauteilen (16) durch Zusammenstecken herstellbar ist, insbesondere unter Zwischenschaltung einer oder mehrerer Aufnahmen, wobei die flächigen Bauteile (16) vorzugsweise aneinander festlegbar sind, vor allem durch Schweißen, Kleben o.ä..

10. Möbel (30) nach einem der Ansprüche 1 bis 9, **dadurch gekennzeichnet, dass** eine Buchse (31) vorgesehen ist, welche die erste (20) und die zweite Platte (22) bildet, wobei die Buchse (31) über je eine erste (21) und eine zweite Ausnehmung (23) und eine Platine (50) verfügt und eine Tragstange (10) in die Buchse (31) einbringbar ist und wobei die Buchse (31) in einem Möbelstück anordbar ist.

11. Möbel (30) nach einem der Ansprüche 1 bis 9, **dadurch gekennzeichnet, dass** ein Gehäuse (32) vorgesehen ist, welches die erste (20) und die zweite Platte (22) bildet, wobei die erste Platte (20) über mehrere erste (21) und die zweite Platte (22) über mehrere zweite Ausnehmungen (23) verfügt,
wobei vorzugsweise eine einzige Platine (50) in Einsteckrichtung (15) unterhalb der zweiten Ausnehmungen (23) angeordnet ist und zwar derart, dass unterhalb jeder der zweiten Ausnehmungen (23) ein paar von Gegenkontaktstellen (51, 52) auf der Platine (50) vorhanden ist
und wobei in die ersten (21) und zweiten Ausnehmungen (23) grundsätzlich jeweils eine Tragstange (10) einbringbar ist, wobei jedoch im konkreten Anwendungsfall die Anzahl und Anordnung der verwendeten Tragstangen (10) unterschiedlich sein kann.

12. Möbel (30) nach einem der Ansprüche 1 bis 11, **dadurch gekennzeichnet, dass** ein oder mehrere weitere Elemente (12) einstückig mit der Tragstange (10) ausgebildet sind und/oder an dieser festlegbar sind.

13. Möbel (30) nach einem der Ansprüche 1 bis 12, **dadurch gekennzeichnet, dass** das Möbel (30) an einer senkrechten Wand montierbar ist, wobei die Tragstange (10) an ihrem einen Ende (11) an einem Zacken des sternförmigen Querschnitts (13) eine Aussparung aufweist, welche dann in die zweite Ausnehmung (23) so eingebracht wird, dass sie nach oben ausgerichtet ist und sich im Montagezustand (30.1) in der zweiten Ausnehmung (23) verhakt.

14. Möbel (30) nach einem der Ansprüche 1 bis 13, **dadurch gekennzeichnet, dass** die Tragstange (10) und/oder die erste Platte (20) und/oder die zweite Platte (22) und/oder das Gehäuse (32) und/oder die Buchse (31) ganz oder teilweise aus Metall und/oder aus Kunststoff und/oder aus Glas und/oder aus einem Verbundmaterial bestehen.

15. Möbel (30) nach einem der Ansprüche 1 bis 14, **dadurch gekennzeichnet, dass** die Tragstange (10) und/oder die erste Platte (20) und/oder die zweite Platte (22) zumindest bereichsweise aus einem durchsichtigen Material bestehen, wobei dieser Bereich beleuchtbar ausgeführt ist.

## Claims

1. Furniture (30) with at least one support rod (10) and with at least one first plate (20) on which the support rod or rods (10) can be installed,
wherein the first plate (20) has one or more first recesses (21), wherein a support rod (10) can be inserted with its one end (11) into each of these first recesses (21),
wherein each of said support rods (10) is vertically mountable to said first plate (20),
wherein the support rod (10) has a star-shaped, axially symmetrical cross-section (13) which tapers (14) at one end (11) facing the first plate (20)
and the shape of the first recesses (21) is adapted to the star-shaped cross-section (13) of the support rod (10), preferably in such a way that it is formed similar to the star-shaped cross-section (13) of the support rod (10),
wherein at least one second recess (23) is provided, which is located in a second plate (22) parallel in the insertion direction (15) of the support rod (10) behind the first recess (21) in the first plate (20),
wherein the second recess (23) is preferably similar, but smaller than the first recess (21)
and wherein the support rod (10) is inserted with its one end (11) into the first and the second recess (23) in several orientations, which are created by rotation of the support rod (10) around the central axis, thus creating an assembly condition (30.1),
**characterised in that**
the support rod (10) comprises electrical conductor tracks (40) by means of which a consumer (18), which is provided directly or indirectly on the support rod (10), can be supplied with electrical energy,
wherein electrical contact points (41) are provided at one end (11) of the support rod (10) in order to supply the electrical conductor tracks (40) with electrical energy
and that a printed circuit board (50) is provided which has electrical mating contact points (51, 52) which can be brought into operative connection with the electrical contact points (41),
wherein the circuit board (50) is designed in such a way that the contact between the electrical contact points (41) and the electrical mating contact points (51, 52) is made, irrespective of the orientation of the support rod (10), merely by inserting the support rod (10) into a first (21) and a second recess (23) respectively.

2. Furniture (30) according to claim 1, **characterised in that** the circuit board (50) has a central first area (53) in the form of a keyhole that forms a first electrical counter contact point (51), while a second area (54) partially surrounding the first area (53) is provided, forming a second electrical mating contact point (52), with the two regions being arranged in such a way that one electrical contact point (41) of the support rod (10) is always in operative connection with the first region (53) and the other electrical contact point (41) of the support rod (10) is always in operative connection with the second region (54), irrespective of the orientation of the support rod (10).

3. Furniture (30) according to claim 1 or 2, **characterised in that** a holder (55) for the board (50) is provided below the second recess (23).

4. Furniture (30) according to one of claims 1 to 3, **characterised in that** the electrical contact points (41) are designed as plug-shaped contact pick-off (42).

5. Furniture (30) according to claim 4, **characterised in that** the support rod (10) has a receptacle (43) into which the contact pick-off (42) can be inserted.

6. Furniture (30) according to one of claims 1 to 5, **characterised in that** the supporting rod (10) is powder-coated.

7. Furniture (30) according to one of claims 1 to 6, **characterised in that** the electrical conductor tracks (40) are printed on the supporting rod (10).

8. Furniture (30) according to one of claims 1 to 6, **characterised in that** the electrical conductor tracks (40) are glued to the supporting rod (10).

9. Furniture (30) according to one of claims 1 to 8, **characterised in that** the supporting rod (10) can be produced from a plurality of preferably congruent flat components (16) by plugging them together, in particular with the interposition of one or more receptacles, the flat components (16) preferably being fixable to one another, in particular by welding, gluing or similar joining method.

10. Furniture (30) according to one of claims 1 to 9, **characterised in that** a bushing (31) is provided which forms the first (20) and the second plate (22), the bushing (31) having a first (21) and a second recess (23) and a plate (50), respectively, and a support rod (10) that can be inserted into the bushing (31), and the bushing (31) being arrangeable in a piece of furniture.

11. Furniture (30) according to any of claims 1 to 9, **characterised in that** a housing (32) is provided which forms the first (20) and the second plate (22), the first plate (20) having a plurality of first (21) and the second plate (22) having a plurality of second recesses (23),
wherein preferably a single printed circuit board (50) is arranged below the second recesses (23) in the insertion direction (15) and in such a way that below each of the second recesses (23) a pair of mating contact points (51, 52) on the printed circuit board (50),
and wherein - as a rule - one support rod (10) can be inserted into each of the first (21) and second recesses (23), although the number and arrangement of the support rods (10) used may differ in the specific application.

12. Furniture (30) according to one of claims 1 to 11, **characterised in that** one or more additional elements (12) are formed integrally with the supporting rod (10) and/or can be fixed to the latter.

13. Furniture (30) according to one of claims 1 to 12, **characterised in that** the furniture (30) can be mounted on a vertical wall, the supporting rod (10) having a recess at its one end (11) on a tooth of the star-shaped cross-section (13), which is then inserted into the second recess (23) in such a way that it is directed upwards and hooks into the second recess (23) in the mounted state (30.1).

14. Furniture (30) according to one of claims 1 to 13, **characterised in that** the supporting rod (10) and/or the first plate (20) and/or the second plate (22) and/or the housing (32) and/or the bushing (31) are entirely or partially made of metal and/or of plastic and/or of glass and/or of a composite material.

15. Furniture (30) according to one of claims 1 to 14, **characterised in that** the supporting rod (10) and/or the first panel (20) and/or the second panel (22) consist at least in part of a transparent material, this area being designed to be illuminable.

## Revendications

1. Meuble (30) pourvu d'au moins une tige support (10) et d'au moins une première plaque (20) sur laquelle la tige support ou les tiges supports (10) peuvent être installées,
sachant que la première plaque (20) présente un ou plusieurs évidements (21), sachant que dans chacun de ces premiers évidements (21) peut être introduite l'extrémité (11) d'une tige support (10),
sachant que chacune des tiges supports (10) est montable verticalement contre la première plaque (20),
sachant que la tige support (10) présente une section (13) en étoile à symétries axiales, section qui va en s'amincissant (14) en direction de l'extrémité (11) regardant la première plaque (20)
et que la forme des premiers évidements (21) est adaptée à la section (13) en étoile de la tige support (10), de préférence de sorte à être configurée de manière similaire à la section (13) en étoile de la tige support (10),
sachant qu'est prévu au moins un deuxième évidement (23) qui se trouve dans une deuxième plaque (22) parallèlement dans le sens d'enfichage (15) de la tige support (10), derrière le premier évidement (21) ménagé dans la première plaque (20),
sachant que le deuxième évidement (23) est configuré de préférence similaire au premier évidement (21), mais de plus petite taille
et que la tige support (10) peut être enfichée par son extrémité (11) dans le premier
et le deuxième évidement (23) selon plusieurs orientations engendrées par la rotation de la tige support (10) sur son axe médian, et que cela engendre un état de montage (30.1),
**caractérisé en ce que**
la tige support (10) comprend des pistes conductrices (40) au moyen desquelles un consommateur (18) prévu indirectement ou directement contre la tige support (10) peut être alimenté en énergie électrique,
sachant qu'à un extrémité (11) de la tige support (10) sont prévus des points de contact (41) électriques pour alimenter les pistes conductrices (40) en énergie électrique
et qu'une platine (50) est prévue, qui présente des points de contact antagonistes (51, 52) électriques, qu'il est possible d'amener en liaison effective avec les points de contacts (41) électriques,
sachant que la platine (50) est conçue de sorte que l'établissement du contact entre les points de contact (41) électriques et les points de contact antagonistes (51, 52) électriques a lieu indépendamment de l'orientation de la tige support (10), simplement en introduisant la tige support (10) dans respectivement un premier (21) et un deuxième (23) évidement.

2. Meuble (30) selon la revendication 1, **caractérisé en ce que** la platine (50) présente une première zone centrale (53) configurée en forme de trou de serrure et qui forme un premier point de contact antagoniste (51) électrique, tandis qu'est prévue une deuxième zone (54) entourant en partie la première zone (53), deuxième zone qui forme un deuxième point de contact antagoniste (52) électrique, sachant que les deux zones sont disposées de telle manière qu'un point de contact (41) électrique de la tige support (10) se trouve toujours en liaison efficace avec la première zone (53) et qu'un autre point de contact (41) électrique de la tige support (10) se trouve toujours en contact efficace avec la deuxième zone (54), indépendamment de l'orientation de la tige support (10).

3. Meuble (30) selon la revendication 1 ou 2, **caractérisé en ce qu'**en dessous du deuxième évidement (23) est prévu un support (55) pour la platine (50).

4. Meuble (30) selon l'une des revendications 1 à 3, **caractérisé en ce que** les points de contact (41) électriques sont configurés en capteurs (42) en forme de connecteurs pour établir le contact.

5. Meuble (30) selon la revendication 4, **caractérisé en ce que** la tige support (10) présente un logement (43) dans lequel peut être amené le capteur (42) établissant le contact.

6. Meuble (30) selon l'une des revendications 1 à 5, **caractérisé en ce que** la tige support (10) présente un revêtement pulvérulent.

7. Meuble (30) selon l'une des revendications 1 à 6, **caractérisé en ce que** les pistes conductrices (40) électriques sont imprimées sur la tige support (10).

8. Meuble (30) selon l'une des revendications 1 à 6, **caractérisé en ce que** les pistes conductrices (40) électriques sont collées sur la tige support (10).

9. Meuble (30) selon l'une des revendications 1 à 8, **caractérisé en ce que** la tige support (10) peut être fabriquée par enfichage à partir de plusieurs composants plats (16) de préférence mutuellement congruents, notamment en intercalant un ou plusieurs logements, sachant que les composants plats (16) peuvent préférentiellement être immobilisés les uns contre les autres, principalement par soudage, collage ou similaire.

10. Meuble (30) selon l'une des revendications 1 à 9, **caractérisé en ce qu'**est prévue une douille (31) formant la première plaque (20) et la deuxième plaque (22), sachant que la douille (31) dispose respectivement d'un premier évidement (21) et d'un second évidement (23) et d'une platine (50), et qu'une tige support (10) peut être introduite dans la douille (31) et sachant que la douille (31) peut être disposée dans un meuble.

11. Meuble (30) selon l'une des revendications 1 à 9, **caractérisé en ce qu'**est prévu un boîtier (32) qui forme la première plaque (20) et la deuxième plaque (22), sachant que la première plaque (20) dispose de plusieurs premiers évidements (21) et la deuxième plaque (22) dispose de plusieurs seconds évidements (23),
sachant que de préférence une seule platine (50) est disposée en dessous des seconds évidements (23) dans le sens d'enfichage (15), de telle manière qu'en dessous de chacun des seconds évidements (23) une paire de points de contacts antagonistes (51, 52) est présente sur la platine (50)
et sachant que peut être introduite respectivement une tige support (10) dans les premiers évidements (21) et seconds évidements (23), sachant toutefois que dans le cas d'application concret le nombre et la disposition des tiges supports (10) utilisées peuvent être différents.

12. Meuble (30) selon l'une des revendications 1 à 11, **caractérisé en ce qu'**un ou plusieurs autres éléments (12) sont configurés monobloc avec la tige support (10) et/ou qu'ils peuvent être fixés contre elle.

13. Meuble (30) selon l'une des revendications 1 à 12, **caractérisé en ce que** le meuble (30) peut être monté contre un mur vertical, sachant que la tige support (10) présente à une extrémité (11) un évidement contre une dent de la section en étoile (13), évidement qui est ensuite introduit dans le deuxième évidement (23) de sorte à être orienté vers le haut et à s'accrocher, à l'état monté (30.1), dans le deuxième évidement (23).

14. Meuble (30) selon l'une des revendications 1 à 13, **caractérisé en ce que** la tige support (10) et/ou la première plaque (20) et/ou la deuxième plaque (22) et/ou le boîtier (32) et/ou la douille (31) sont entièrement ou partiellement en métal et/ou en plastique et/ou en verre et/ou en matériau composite.

15. Meuble (30) selon l'une des revendications 1 à 14, **caractérisé en ce que** la tige support (10) et/ou la première plaque (20) et/ou la deuxième plaque (22) se composent au moins dans une zone d'un matériau transparent, sachant que cette zone est réalisée éclairable.
